(19) Europäisches Patentamt / European Patent Office / Office européen des brevets

(11) **EP 2 575 311 B1**

(12) **FASCICULE DE BREVET EUROPEEN**

(45) Date de publication et mention
de la délivrance du brevet:
**28.03.2018 Bulletin 2018/13**

(51) Int Cl.:
***H04L 27/00*** *(2006.01)*

(21) Numéro de dépôt: **12184889.9**

(22) Date de dépôt: **18.09.2012**

(54) **Système de démodulation**

System zur Demodulation

System for demodulation

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.09.2011 FR 1102967**

(43) Date de publication de la demande:
**03.04.2013 Bulletin 2013/14**

(73) Titulaire: **Thales
92400 Courbevoie (FR)**

(72) Inventeurs:
• **Pillet, Grégoire
75013 Paris (FR)**
• **Morvan, Loïc
91400 Orsay (FR)**
• **Dolfi, Daniel
91400 Orsay (FR)**

(74) Mandataire: **Joubert, Cécile et al
Marks & Clerk France
Counseils en Propriete Industrielle
Immeuble "Visium"
22, avenue Aristide Briand
94117 Arcueil Cedex (FR)**

(56) Documents cités:
**EP-A1- 2 019 484      WO-A1-88/02196
US-A- 5 150 128**

• **NORIMATSU S ET AL: "An 8 Gb/s QPSK optical
homodyne detection experiment using
external-cavity laser diodes", IEEE PHOTONICS
TECHNOLOGY LETTERS, IEEE SERVICE
CENTER, PISCATAWAY, NJ, US, vol. 4, no. 7, 1
juillet 1992 (1992-07-01) , pages 765-767,
XP011410448, ISSN: 1041-1135, DOI:
10.1109/68.145266**
• **OKAMOTO K ET AL: "Nearly Shot-Noise-Limited
Performance of Dual-Channel Linear Optical
Sampling for Ultrafast DPSK Signals", IEEE
JOURNAL OF QUANTUM ELECTRONICS, IEEE
SERVICE CENTER, PISCATAWAY, NJ, USA, vol.
45, no. 6, 1 juin 2009 (2009-06-01), pages 711-719,
XP011257363, ISSN: 0018-9197**

EP 2 575 311 B1

**Description**

L'invention porte sur un dispositif de démodulation de signaux. Elle s'applique par exemple à la démodulation de signaux radar, la démodulation de signaux lidar-radar et la démodulation des signaux codés QAM (télécommunication, télévision). Plus particulièrement l'invention concerne un dispositif de démodulation d'un signal hyperfréquence utilisant la démodulation de type I/Q

Une démodulation d'un signal de fréquence f appartenant au domaine des hyperfréquences (typiquement f est comprise entre 100 MHz et 40 Ghz,) permet de déterminer l'amplitude et/ou la phase (ou une combinaison des deux) du signal de fréquence f.

L'expression générale d'un signal QAM (Modulation d'amplitude en quadrature ou « Quadrature amplitude modulation» en anglais) autour de la fréquence porteuse f est :

$$S(t) = A(t).cos(2\pi ft+\varphi(t))=I(t).cos(2\pi ft)+Q(t).sin(2\pi ft)$$

Notons bien que f est une fréquence de référence. Ce n'est pas nécessairement la fréquence centrale du signal S(t). La fréquence centrale de S(t) est f+d/dt($\varphi$(t)). Démoduler ce signal S(t) signifie déterminer son amplitude A(t) et sa phase $\varphi$(t), ou de manière équivalente son amplitude en phase I(t) et son amplitude en quadrature Q(t).

Une méthode couramment utilisée est la démodulation en phase et en quadrature (couramment appelée démodulation I/Q) qui permet d'obtenir directement les valeurs I(t) et Q(t). Pour cela le signal S(t) est multiplié d'une part par cos(2$\pi$ft) et d'autre part par sin(2$\pi$ft), puis un filtrage basse fréquence est effectué. De cette manière, on obtient des signaux proportionnels à I(t) pour la partie du signal S(t) qui a été multiplié par le cosinus, et à Q(t) pour la partie du signal S(t) qui a été multipliée par le sinus. Pour mettre en oeuvre cette méthode, le problème principal est de disposer à la fois de cos(2$\pi$ft) et de sin(2$\pi$ft).

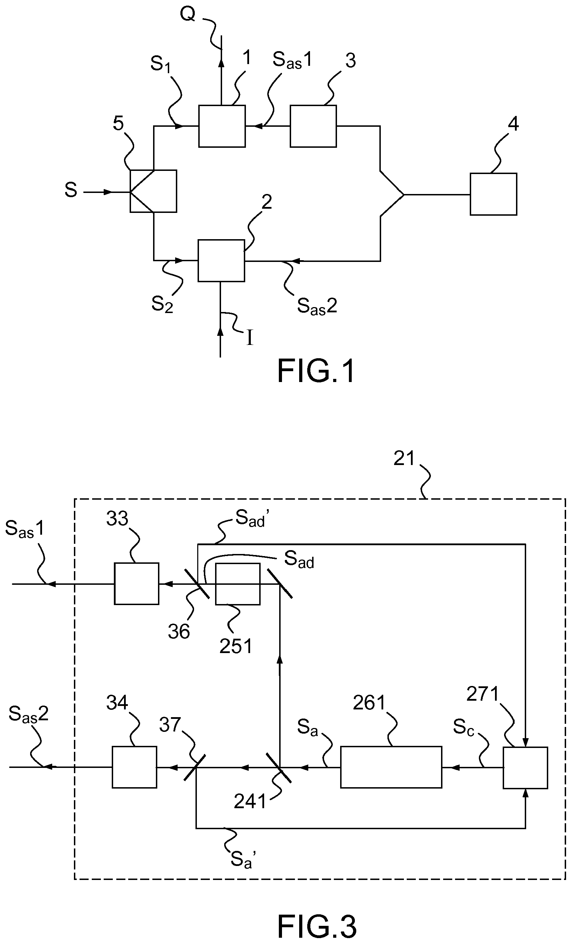

Dans les systèmes couramment utilisés, on ne dispose pas du signal sin(2$\pi$ft), et il est nécessaire de la générer à partir du signal cos(2$\pi$ft). Cette étape correspond à un déphasage de $\pi$/2. La figure 1 décrit un tel dispositif selon l'état de la technique utilisant un déphaseur $\pi$/2. Le signal S(t) est séparé en deux partie S1(t) et S2(t) à l'aide de moyens de séparation 5. Un oscillateur 4 à la fréquence porteuse f génère le signal cos(2$\pi$ft) et est séparé en deux parties. Une première partie est déphasée de $\pi$/2 par le déphaseur 3, formant ainsi le signal en quadrature Sas1 en sin(2$\pi$ft), qui est multiplié par S1(t) à l'aide d'un multiplieur 1. Puis, suite à différents traitements de type filtrage par exemple, le signal Q est obtenu. La deuxième partie en cos(2$\pi$ft) forme le signal en phase Sas2 qui est multiplié par S2(t) à l'aide d'un multiplieur 2. Puis, suite à différents traitements de type filtrage par exemple, le signal I est constitué.

Les déphaseurs hyperfréquence usuels permettent généralement de réaliser le déphasage de $\pi$/2 pour une bande de fréquence autour d'une fréquence f prédéfinie. La quadrature (+/- quelques degrés) est alors obtenue sur une bande étroite, typiquement de l'ordre de 10% autour de la fréquence f. La quadrature est ainsi valable sur une bande étroite et est peu précise.

Le problème de bande passante peut être amélioré en utilisant un déphaseur accordable assorti d'un asservissement sur la phase, tel que décrit par exemple dans le document US5150128. Néanmoins, un tel dispositif rend le montage plus complexe et les déphaseurs accordables présentent plusieurs défauts : la bande passante est assez réduite (typiquement quelques dizaines de pourcents), ils ont de fortes pertes (typiquement 6 dB), leur temps de réponse est lent (typiquement la $\mu$s).

La démodulation I/Q n'est pas la seule méthode de démodulation existante. Une autre méthode de démodulation, la démodulation décalée en fréquence, est couramment utilisée. Le principe est de multiplier le signal reçu S(t) par un signal à une fréquence qui est différente : sin(2$\pi$f2t). Après multiplication et filtrage basse fréquence, on obtient le signal A(t).cos(2$\pi$(f-f2)t+$\varphi$(t)). Ce signal peut être analysé (numériquement par exemple) de manière à extraire l'information A(t) et $\varphi$(t) (ou de manière équivalente I(t) et Q(t)). La démodulation décalée en fréquence présente deux contraintes :

(I) elle ne fonctionne que si les bandes passantes des signaux A(t) et $\varphi$(t) (ou de manière équivalente I(t) et Q(t)) sont inférieures à la fréquence |f-f2|, il faut donc choisir f2 suffisamment éloigné de f :

|f-f2|> fréquence maximum de I(t) et |f-f2|> fréquence maximum de Q(t).

(II) la bande passante d'analyse nécessaire pour extraire l'information A(t) et $\varphi$(t) est :

|f-f2| + max (fréquence max de (I(t), fréquence max de Q(t)).

La démodulation I/Q présente ainsi un avantage par rapport à la démodulation décalée en fréquence car elle ne présente pas ces deux contraintes : elle permet de directement mesurer les deux fonctions I(t) et Q(t) qui définissent le signal S(t). La bande passante nécessaire pour analyser ces deux signaux est donc directement, pour le signal I(t), fréquence max de (I(t)) et pour le signal Q(t), fréquence max de Q(t). Cette mesure directe et sans ambiguïté est valable quelle que soit la bande passante de ces signaux.

Un but de la présente invention est notamment de palier l'inconvénient de la démodulation I/Q précitée utilisant un déphaseur, en proposant un dispositif de démodulation d'un signal hyperfréquence en phase et en quadrature associé à une boucle à verrouillage de fréquence. Cette architecture permet de garantir une quadrature parfaite quelque soit le type de déphaseur et de garantir la stabilité de la fréquence f.

A cet effet un premier aspect de l'invention a pour objet un système de démodulation I/Q selon la revendication 1 comprenant un dispositif à verrouillage de fréquence. Ce type de démodulation I/Q utilise une boucle à verrouillage de fréquence (« Frequency Locked Loop » ou FLL) à la place d'un déphaseur $\pi/2$ et permet ainsi une stabilisation de la fréquence porteuse f du signal hyperfréquence. Un autre avantage de certaines variantes de réalisation est une démodulation réalisable sur un large intervalle de fréquence f.

Ainsi, le dispositif permet de réaliser simultanément deux fonctions :

- il stabilise la fréquence du générateur de démodulation ce qui permet d'augmenter la dynamique de la mesure : en effet les instabilités de fréquence et de phase du générateur (communément caractérisées par la gigue et la largeur de raie) sont néfastes à la bonne réception du signal car elles réduisent le rapport signal à bruit et la dynamique de la mesure.
- la quadrature (permettant de réaliser la démodulation I/Q du signal reçu) est parfaitement assurée par le dispositif de stabilisation.

En contrepartie la fréquence de démodulation est fixée sur une des positions stables de l'asservissement de fréquence. Elle peut donc présenter un écart de fréquence df avec le signal reçu. Ceci induit un accroissement de la bande d'analyse exactement égal à df. Pour conserver l'avantage de la démodulation I/Q par rapport à la démodulation décalée en fréquence, il est nécessaire que df soit inférieur au maximum entre (fréquence max de (I(t)) et (fréquence max de Q(t)).

Dans un mode de réalisation, le signal asservi est par ailleurs déphasé par un deuxième déphaseur et le comparateur de phase compare les phases respectives des deux signaux asservis déphasés

Dans un mode de réalisation le déphaseur comprend un filtre dispersif, qui a une forte dépendance de la fréquence en fonction de la phase, permettant ainsi d'obtenir un dispositif plus sensible et précis pour la détermination de la fréquence démodulée.

Dans un mode de réalisation le déphaseur comprend une ligne à retard, qui constitue la méthode la plus simple pour obtenir une forte dépendance de la fréquence en fonction de la phase, soit une forte sensibilité, tout en permettant au dispositif de fonctionner sur un large intervalle de fréquence f.

Par exemple, le déphaseur est obtenu par des moyens optiques.

Selon une variante le déphaseur comprend un filtre résonant optique. Les filtres optiques peuvent être très résonnant et donc très dispersif, c'est-à-dire qu'ils induisent une forte dépendance de la fréquence en fonction de la phase, et sont généralement très compacts.

Selon une autre variante le déphaseur comprend une ligne à retard agissant sur le faisceau optique. Les lignes à retard, par exemple en fibre optique, sont très peu chères, présentent peu de pertes et sont très compactes (10 km de retard équivaut à 50% de pertes et peuvent tenir dans un litre). Ainsi la démodulation peut être effectuée pour un ensemble de fréquences discrètes qui sont réparties sur un large intervalle et qui sont plus resserrées que lorsque le déphasage est effectué directement sur l'onde hyperfréquence.

Avantageusement la ligne à retard est une fibre optique, qui présente peu de perte, est compacte et de faible coût.

Dans un mode de réalisation le déphaseur comprend un laser générant une onde optique modulée à une fréquence appartenant au domaine des hyperfréquences et une photodiode rapide. Le déphasage sur l'un des bras est ainsi réalisé en utilisant des moyens optiques, le reste de la chaîne fonctionnant directement avec le signal hyperfréquence, ce qui permet l'utilisation de composant hyperfréquence standards

Selon un mode de réalisation le générateur accordable est un laser générant une onde optique modulée à une fréquence appartenant au domaine des hyperfréquences. Le déphasage peut ainsi être généré optiquement et sans conversion électrique/optique sur les deux parties du signal asservi destinées à être recombinées pour la comparaison de leur phase respectives. Les conversions électrique optique consomment beaucoup et sont chères.

Avantageusement, le signal asservi et le signal asservi déphasé sont des faisceaux optiques, dont une partie est prélevée par des moyens de prélèvement, chacune desdites parties constituant une entrée du comparateur de phase.

Selon une variante chacune desdites parties sont recombinées optiquement à l'aide d'un composant non linéaire dont la fonction est de comparer les phases.

La comparaison de phase est effectuée optiquement et ne nécessite pas de composant optoélectronique de transformation de l'onde optique en onde hyperfréquence et de comparateur de phase hyperfréquence, l'ensemble du traitement s'effectuant par voie optique.

Le signal de sortie dudit composant est transformé en un signal électrique de commande à l'aide d'un composant optoélectronique.

Selon une variante l'une au moins desdites parties est transformée en signal électrique avant l'entée du comparateur de phase.

Selon une variante, lorsque qu'un générateur accordable tel qu'un laser générant une onde optique est utilisé, le signal asservi et le signal asservi déphasé sont chacun transformés en signal électrique hyperfréquence à l'aide d'un composant optoélectronique afin de générer lesdits signaux en phase et en quadrature pour effectuer la démodulation I/Q.

Selon une variante, lorsqu'un générateur accordable tel qu'un laser générant une onde optique est utilisé, le signal asservi et le signal asservi déphasé sont chacun transformés en signal électrique hyperfréquence à l'aide d'un composant optoélectronique, dont une partie est prélevée par des moyens de prélèvement, chacune desdites parties constituant une entrée du comparateur de phase.

Selon un autre aspect de l'invention, il est également proposé un système d'émission et de réception pour radar selon la revendication 16. Un tel système permet d'effectuer une partie ou la totalité du déphasage et de l'asservissement en fréquence par traitement optique. Le traitement optique permet d'obtenir une meilleure précision de l'asservissement en fréquence, un dispositif compact et fonctionnant sur un large intervalle de fréquence f.

Selon un autre aspect de l'invention, il est également proposé un système d'émission et de réception pour lidar selon la revendication 17. Un tel système permet de générer un lidar agile et stabilisé en fréquence, et dont le signal de réception peut être analyser par démodulation I/Q.

D'autres caractéristiques et avantages de la présente invention apparaîtront à la lecture de la description détaillée qui suit faite en regard des dessins annexés donnés à titre d'exemple non limitatifs et sur lesquels :

- la figure 1 illustre le principe de démodulation I/Q selon l'état de la technique, en utilisant un déphaseur $\pi/2$.
- la figure 2 présente le principe de l'invention, où l'obtention des deux signaux d'analyse en quadrature nécessaires à la démodulation I/Q s'effectue via une architecture de boucle à verrouillage de fréquence.
- la figure 3 représente une variante de l'invention où le générateur du signal asservi est un laser, la comparaison de phase s'effectuant avec, en entrée du comparateur, des faisceaux optique.
- la figure 4 présente une variante de l'invention où des convertisseurs optique/hyper sont insérés de sorte que la comparaison de phase s'effectue avec, en entrée du comparateur, des signaux hyperfréquence.
- la figure 5 représente une chaîne d'émission/réception intégrable dans un radar mettant en oeuvre une démodulation I/Q selon l'invention.
- la figure 6 représente une chaîne d'émission/réception intégrable dans un lidar mettant en oeuvre une démodulation I/Q selon une variante de l'invention.

## DESCRIPTION DETAILLEE DE L'INVENTION

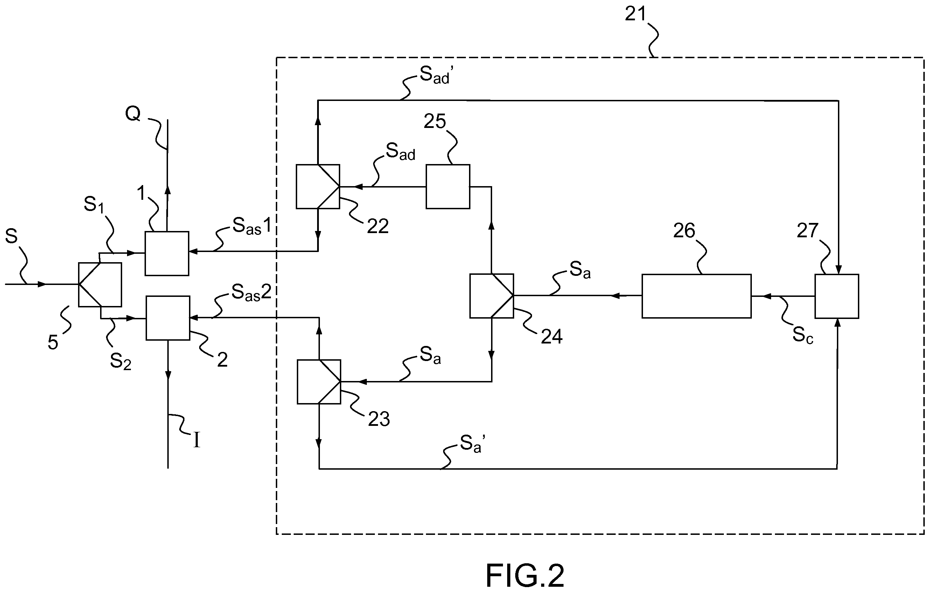

Le principe d'une boucle de verrouillage de fréquence (« FLL ») utilisée dans l'invention est décrit sur la figure 2. Le signal Sa délivré par un générateur 26 accordable en fréquence est séparé en deux parties générant deux signaux, dont l'une (ou les deux), est indépendamment déphasées par rapport à l'autre à l'aide d'un déphaseur 25, par exemple par dispersion ou retard. Ces deux parties indépendamment déphasées sont ensuite comparées à l'aide d'un comparateur de phase 27, par exemple un mélangeur hyperfréquence. Le comparateur délivre un signal fonction de la différence des deux phases. Lorsque le comparateur de phase est un mélangeur hyperfréquence, celui-ci délivre une tension proportionnelle au cosinus de la différence de phase. La quadrature entre les deux signaux correspond à une certaine valeur en sortie du comparateur, par exemple 0 lorsque le comparateur est un mélangeur. Le signal issu du comparateur est injecté dans le générateur accordable, sous la forme d'un signal de commande Sc. La fréquence du générateur peut ainsi être asservie de manière à obtenir la quadrature entre les deux voies. L'intérêt de ce type de boucle est que le maintient de la quadrature correspond une stabilisation de la fréquence émise.

Le signal délivré par le générateur est ainsi un signal Sa asservi en fréquence.

La figure 2 illustre le principe de fonctionnement d'un dispositif selon l'invention.

Un générateur accordable 26 génère un signal Sa, qui est séparé en deux parties par des moyens de séparation 24.

La première partie du signal Sa est déphasée d'une phase $\varphi$ à l'aide d'un déphaseur 25. A la sortie du déphaseur, un signal déphasé Sad est obtenu. Ce signal déphasé est séparé en deux voies par des moyens de prélèvement 22. Une voie est utilisée comme une première entrée Sad' d'un comparateur de phase 27, et l'autre voie est utilisée pour la génération du signal en quadrature Sas1 pour la démodulation I/Q.

La deuxième partie du signal Sa n'est pas déphasée et est également séparée en deux voies par des moyens de prélèvement 23. Une voie est utilisé comme la deuxième entrée Sa' du comparateur de phase 27. Le comparateur de phase 27 compare les phases respectives des signaux Sad' et Sa' et délivre un signal de sortie fonction de la différence entre ces deux phases. Ce signal de sortie est utilisé pour générer le signal de commande Sc du générateur accordable 26, de manière à ce que la fréquence de celui-ci soit ajustée afin d'obtenir une différence de phase égale à $\pi/2$ entre le signal Sad d'une part, et le signal Sa d'autre part. Une boucle d'asservissement de la fréquence du signal Sa délivré par le générateur 26 est ainsi mise en oeuvre, permettant simultanément la stabilisation de la fréquence et l'obtention de deux signaux en quadrature, Sad et Sa. L'autre voie est utilisée pour la génération du signal en phase Sas2 pour la démodulation I/Q.

Ainsi, le signal en phase Sas2, issu du générateur, et le signal en quadrature Sas1 obtenu à l'aide du déphaseur, sont générés par un dispositif 21 intégrant une boucle à verrouillage de fréquence. Ils sont ensuite mélangés au signal S à démoduler selon le principe classique de démodulation I/Q.

De manière alternative, la deuxième partie du signal asservi est également déphasée d'une phase $\Psi$ par un déphaseur non représenté, générant un deuxième signal déphasé. Le comparateur de phase compare alors les phases $\varphi$ et $\Psi$ des deux signaux asservis déphasés de la même manière que décrit précédemment..

Selon une variante de l'invention le générateur asservi en fréquence est un générateur hyperfréquence. Le comparateur de phase peut être un mélangeur hyperfréquence qui délivre une tension proportionnelle au cosinus de la différence de phase.

Le déphaseur est par exemple un filtre dispersif ou une ligne à retard agissant sur le signal hyperfréquence.

Lorsque le déphaseur est un filtre dispersif, on obtient un déphasage de $\pi/2$ au voisinage d'une fréquence f. Typiquement avec un filtre résonnant hyperfréquence, on obtient un changement de fréquence f de plus 100 kHz lorsque le déphasage dérive de $\pi$. Ce type de déphaseur permet donc un asservissement fin sur la fréquence f.

Lorsque le déphaseur est obtenu en introduisant un retard opéré directement sur l'onde hyperfréquence, on obtient un déphasage de $\pi/2$ au voisinage de fréquences discrètes $f_k$ (k entier relatif) vérifiant :

$$f_k = 1/2\tau + k/\tau \, ,$$

Les fréquences discrètes sont séparées d'un intervalle $\Delta f = 1/\tau$.

Typiquement des retards $\tau < 100$ ns peuvent être obtenus à l'aide de long retard cablés, d'où un intervalle $\Delta f > 10$ Mhz. Le balayage de la fréquence f de démodulation est obtenu en incrémentant les quadratures, c'est à dire en faisant varier la valeur de k entier relatif en réglant la valeur du retard.

Resserrer les fréquences discrètes asservies est utile pour démoduler des signaux dont la fréquence centrale est arbitraire. Cela permet de réaliser la démodulation I/Q avec un signal asservi à une fréquence plus proche.

Selon une variante de l'invention, le déphaseur peut être réalisé avec un retard obtenu grâce à des moyens optiques. Le déphaseur comprend par exemple un laser délivrant une onde optique modulée par le signal hyperfréquence à retarder, un déphaseur introduisant le retard en agissant sur l'onde optique, et un composant optoélectronique tel une photodiode rapide permettant d'effectuer la transformation de l'onde optique en un signal hyperfréquence.

Le déphaseur comprend par exemple une fibre optique. Avec une fibre optique, on obtient un retard de 0.5 $\mu$s pour une longueur de 100m de fibre. Soit, pour une fibre de 200 km, des retards $\tau$ de l'ordre de 1 ms peuvent être obtenus d'où un intervalle $\Delta f \approx 1$ kHz. Un avantage du retard optique, par rapport à un retard effectué directement sur l'onde hyperfréquence, est donc de resserrer l'intervalle de séparation entre deux fréquences discrètes asservies. L'autre avantage est de profiter de ce long retard pour réaliser une FLL de meilleure sensibilité.

Le déphaseur comprend par exemple un filtre optique résonnant, par exemple un résonateur de type « whispering gallery mode ». Ce type de déphaseur est très compact et très sensible. Typiquement on obtient des sensibilités à la dérive de fréquence équivalente à plusieurs kilomètres de fibre avec un composant de type Wispering Gallery Mode de quelques millimètres de diamètre.

Selon une variante de l'invention, le signal asservi en fréquence est un signal optique généré par un laser 261, l'onde optique étant modulée à la fréquence du signal hyper, tel que décrit figure 3. Le signal optique est séparé en deux voies à l'aide de moyens de séparation 241, et un déphasage est opéré par un déphaseur 251 obtenu par des moyens optiques, par exemple un filtre optique résonnant ou une fibre optique tel que décrit précédemment et possédant les même avantages. L'utilisation d'une fibre optique permet ainsi d'obtenir un déphasage de $\pi/2$ au voisinage de fréquences discrètes $f_k$ (k entier relatif) vérifiant $f_k = 1/2\tau + k/\tau$, avec un retard $\tau$ pouvant atteindre des valeurs de l'ordre de la ms, l'intervalle entre deux fréquences discrètes asservies étant alors typiquement de l'ordre du kHz.

Selon un mode de réalisation décrit figure 3, une partie Sa', Sad' des deux signaux optiques Sa, Sad est prélevée par les moyens de prélèvement 36, 37. Les deux parties constituent deux voies, l'une formée par le signal optique Sa', l'autre formée par le signal optique Sad', qui se recombinent au niveau du comparateur de phase, dont elles constituent les deux entrées.

Cette recombinaison comparant les phases peut être effectuée de manière optique par un composant non linéaire, tel qu'un cristal doubleur de fréquence.

EP 2 575 311 B1

Le signal de sortie optique est transformé en signal électrique de commande Sc pour le laser par un composant optoélectronique, comprenant typiquement une photodiode.

Cette recombinaison comparant les phases peut également être effectuée de manière hybride, une des voies étant transformée en signal électrique avant l'entrée sur le comparateur de phase. Un exemple de comparateur hybride est un modulateur d'amplitude optique de type Mach Zehnder fibré en LiNbO3.

Cette recombinaison comparant les phases peut également être effectuée de manière électrique à l'aide de deux composants de transformation optique/hyper.

Les signaux optiques, l'un issu du déphaseur Sad, l'autre issu directement du signal de sortie du laser Sa sont chacun transformés en signaux électrique hyperfréquence à l'aide de composants optoélectroniques 33, 34 situés en aval des moyens de prélèvement 36,37, afin d'être utilisés comme signaux en phase et en quadrature pour la démodulation I/Q.

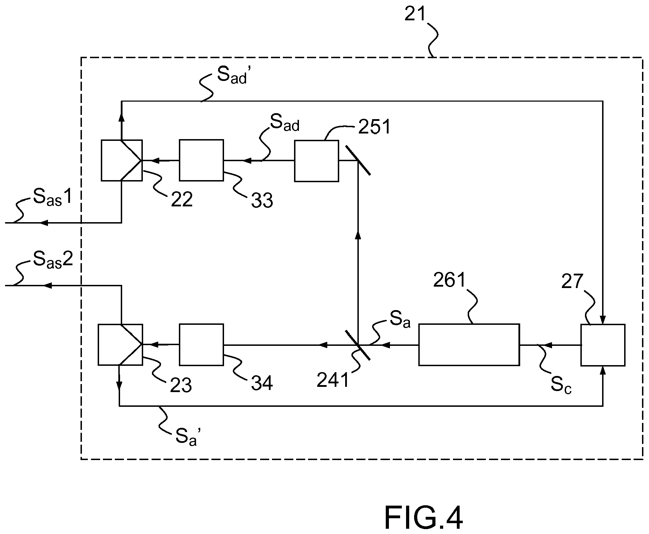

Selon un autre mode de réalisation, décrit sur la figure 4, les faisceaux optiques obtenus en sortie du laser Sa, et du déphaseur Sad, sont transformés en signaux hyperfréquence à l'aide de composants optoélectroniques 33,34 positionnés en amont des moyens de prélèvement 22,23. Une partie Sa', Sad' de ces signaux hyperfréquence Sa, Sad est prélevée par les moyens de prélèvement 22, 23 pour la comparaison de phase. Le comparateur de phase 27 possède selon cette option deux entrées électriques hyperfréquence. Le comparateur de phase peut être un mélangeur hyperfréquence qui délivre une tension proportionnelle au cosinus de la différence de phase.

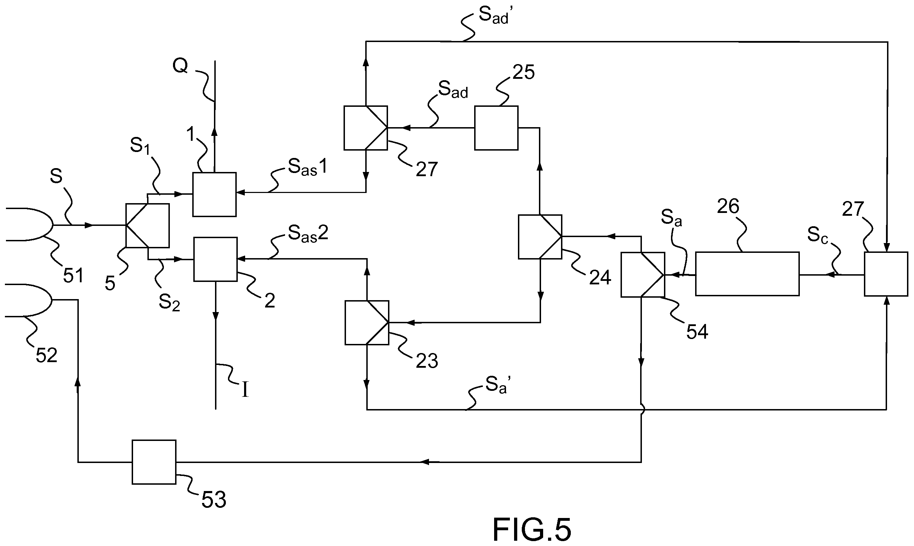

La figure 5 présente une chaîne d'émission/réception utilisant un dispositif tel que décrit ci-dessus, intégré dans une chaîne d'émission/réception pour application radar selon l'invention. La chaîne comprend une antenne d'émission 52 dont le signal d'émission est issu du signal asservi délivré par le générateur, amplifié par un amplificateur 53. Le signal émis a donc une fréquence f égale à la fréquence du signal asservi. La chaîne comprend en outre une antenne de réception 51 qui reçoit un signal réfléchi (par exemple un écho de cible par exemple). Ce signal de réception est amplifié par un amplificateur (non représenté) avant d'être séparé en deux parties par le moyen de séparation 5 afin d'être analysé par démodulation I/Q. Par construction, les signaux en phase Sas2 et en quadrature Sas1 ont la même fréquence f que le signal à analyser. L'avantage d'un tel système est de fonctionner avec une fréquence stabilisée à une valeur correspondant à l'obtention de signaux en quadrature pour la démodulation I/Q. Le système est large bande par construction.

Le dispositif d'émission/réception selon l'invention s'applique également à une chaîne d'émission/réception pour les télécommunications.

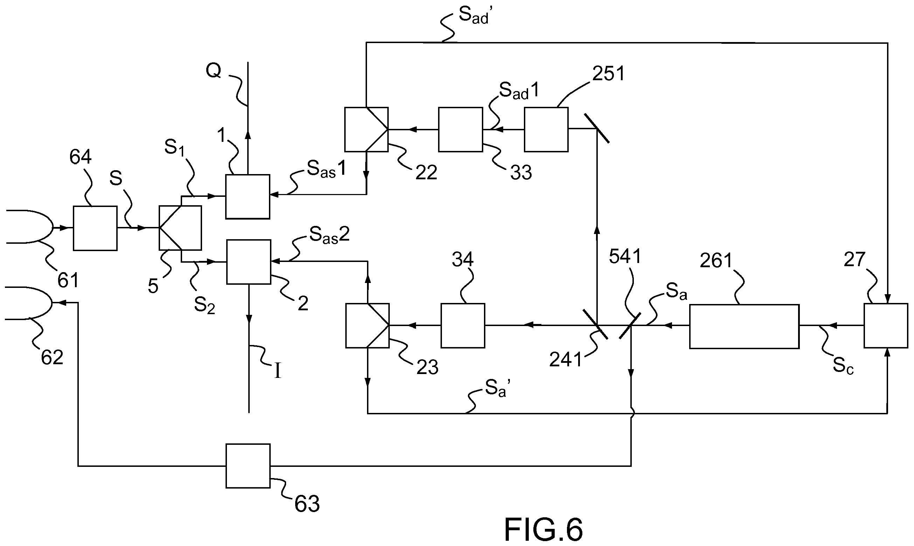

La figure 6 présente une chaîne d'émission/réception utilisant un dispositif tel que décrit ci-dessus, intégré dans une chaîne d'émission/réception pour application lidar selon l'invention. L'ensemble de la chaîne, à l'exception de la démodulation I/Q, utilise un faisceau optique modulé à une fréquence porteuse hyperfréquence.

La chaîne comprend une lentille d'émission 62 dont le signal d'émission est issu du signal asservi délivré par le laser 261. Le signal est amplifié par un amplificateur 63, par exemple un amplificateur à fibre optique dopé Erbium. Le signal d'émission est donc un signal optique modulé à la fréquence asservie f. La chaîne comprend en outre une lentille de réception 61 qui collecte l'onde optique réfléchie. Ce signal optique à analyser est transformé en signal hyperfréquence à l'aide d'un composant électronique 64 comprenant par exemple une photodiode et un amplificateur, avant d'être séparé en deux parties par le moyen de séparation (5) afin de réaliser son analyse par démodulation I/Q

Le signal optique issu du laser Sa est séparé en deux parties et la mise en quadrature de la modulation hyperfréquence est effectué par asservissement de la fréquence tel que décrit précédemment. Cet asservissement peut s'effectuer avec, en entrée du comparateur, soit deux signaux optiques, soit un signal optique et un signal électrique hyperfréquence, soit avec deux signaux hyperfréquence. Dans ce dernier cas, les composants optoélectroniques 33, 34 de transformation optique/hyper sont positionnés en amont des moyens de prélèvement 22, 23 pour la comparaison de phase.

La chaîne d'émission/réception pour lidar ainsi obtenue permet une détection très précise du mouvement de la cible grâce à la stabilisation de la fréquence couplée à une démodulation I/Q large bande par construction.

Un exemple de mise en oeuvre d'une chaîne d'émission/réception pour lidar va être décrit à titre d'exemple non limitatif.

Le laser 261 est un laser bi-fréquence émettant à une longueur d'onde de 1.5 μm. Il émet un signal optique modulé en intensité à la fréquence f, typiquement avec une puissance de 30 mW.

La fréquence hyper f est ajustable en appliquant une tension directement sur un élément électro-optique du laser. La fréquence moyenne est ajustée par la température entre 1 et 5GHz (1GHz par °C). Le réglage fin s'effectue à l'aide d'une tension avec un coefficient d'accord de l'ordre de 1 MHz/V. La fréquence de modulation hyper d'un tel laser est instable, variant de plusieurs Mégahertz en quelques secondes. Une fraction du signal issu du laser est séparée en deux parties constituant deux faisceaux (environ 2 mW chacun) par un séparateur de faisceau 241. L'autre fraction du signal issu du laser est dirigée via le séparateur 541 vers la lentille d'émission.

Une partie du faisceau Sa n'est pas déphasée et est détectée directement par une photodiode 34.

L'autre partie du faisceau est retardée par une ligne à retard en fibre optique, de 100 m de long, générant le faisceau Sad. On a ainsi τ = 0.5 μs soit Δf ≈2 MHz. Puis, le faisceau est détecté par une photodiode.

Les deux signaux électriques hyperfréquence ainsi obtenus Sa et Sad sont ensuite amplifiés puis prélevés par les moyens 22, 23. Les parties prélevées Sa' et Sad' sont comparées en phase à l'aide d'un mélangeur hyperfréquence 27. Le signal électrique issu du mélangeur est amplifié, filtré et réinjecté sur l'élément électro-optique du laser, réalisant ainsi un asservissement de la fréquence f de modulation qui est stabilisée sur une fréquence f = $f_{offset}$ + k/$\tau$, k entier relatif. La stabilisation obtenue est meilleure que la dizaine de kHz en quelques secondes (à comparer aux quelques MHz sans asservissement).

Les parties des signaux hyperfréquence non prélevées pour la comparaison de phase sont utilisées comme signaux en quadrature Sas2 et en phase Sas1 pour la démodulation I/Q.

La partie du signal optique destinée à l'émission est amplifiée à l'aide d'un amplificateur à fibre optique dopé Erbium 63. Une partie du signal rétrodiffusé est collecté dans une fibre optique et détecté par une photodiode rapide 64.

Le signal hyperfréquence obtenu est par construction modulé à la fréquence f, et l'analyse du mouvement de la cible est effectuée par démodulation I/Q.

La modulation du signal est tout d'abord détectée puis amplifiée. Le signal S à analyser est ensuite séparé en deux parties S1 et S2. La deuxième partie S2 est mélangée via un mélangeur 2 à la partie du signal non retardé Sas2. Le signal résultant de ce mélange correspond au signal I d'une détection I/Q classique. La première partie S1 est mélangée via un mélangeur 1 à la partie du signal qui a été retardée Sas1, le déphasage étant par construction égal à $\pi$/2. Le signal résultant de ce mélangeur correspond au signal Q d'une détection I/Q classique

**Revendications**

1. Système de démodulation I/Q d'un signal hyperfréquence (S) à partir d'un signal hyperfréquence en phase (Sas2) et un signal hyperfréquence en quadrature (Sas1),
   **caractérisé en ce qu'**il comprend un dispositif à verrouillage de fréquence (21) pour générer lesdits signaux en phase et en quadrature (Sas2, Sas1), ledit dispositif à verrouillage de fréquence comprenant :

   - un générateur (26,261) accordable en fréquence et apte à être commandé par un signal de commande (Sc), ledit générateur délivrant un signal asservi en fréquence (Sa) ;
   - au moins un premier déphaseur (25,251) introduisant un déphasage ($\varphi$) sur le signal asservi et générant en sortie du déphaseur un signal asservi déphasé (Sad) ;
   - ledit déphasage ($\varphi$) étant fonction de la fréquence du signal à déphaser ;
   - un comparateur de phase(27,271) comparant la phase du signal asservi (Sa) et la phase du signal asservi déphasé (Sad) et délivrant un signal de sortie étant fonction de la différence entre lesdites phases ;
   - ledit signal de sortie générant le signal de commande (Sc) dudit générateur (26,261) de sorte que la fréquence dudit générateur (26,261) est adaptée pour que la phase du signal asservi (Sa) et la phase du signal asservi déphasé (Sad) présentent une différence sensiblement égale à un multiple impair de $\pi$/2 ;
   - lesdits signaux asservi (Sa) et signal asservi déphasé (Sad) étant aptes à générer lesdits signaux hyperfréquence en phase (Sas2) et en quadrature (Sas1) aptes à réaliser la démodulation I/Q du signal hyperfréquence (S).

2. Système selon la revendication 1 **caractérisé en ce que** ledit signal asservi (Sa) est par ailleurs déphasé par un deuxième déphaseur et **en ce que** ledit comparateur de phase (27,271) compare les phases respectives des deux signaux asservis déphasés.

3. Système selon les revendications 1 à 2 caractérisé en ce l'au moins un desdits déphaseurs comprend un filtre dispersif.

4. Système selon les revendications 1 à 2 caractérisé en ce l'au moins un desdites déphaseurs comprend une ligne à retard.

5. Système selon l'une des revendications précédentes **caractérisé en ce que** l'au moins un desdits déphaseurs est un déphaseur optique (251) obtenu par des moyens optiques

6. Système selon la revendication 5 **caractérisé en ce que** ledit déphaseur optique comprend un filtre résonant optique.

7. Système selon la revendication 5 **caractérisé en ce que** ledit déphaseur optique comprend une ligne à retard agissant sur le faisceau optique.

8. Système selon la revendication 7 **caractérisé en ce que** ladite ligne à retard est une fibre optique.

9. Système selon l'une des revendications 5 à 8 **caractérisé en ce que** ledit déphaseur optique (251) comprend un laser générant une onde optique modulée à une fréquence appartenant au domaine des hyperfréquences et une photodiode rapide.

10. Système selon l'une des revendications 1 à 8 **caractérisé en ce que** ledit générateur accordable est un laser (261) générant une onde optique modulée à une fréquence appartenant au domaine des hyperfréquences.

11. Système selon la revendication 10 **caractérisé en ce que** ledit signal asservi (Sa) et ledit signal asservi déphasé (Sad) sont des faisceaux optiques, dont une partie (Sa', Sad') est prélevée par des moyens de prélèvement (36, 37), chacune desdites parties constituant une entrée dudit comparateur de phase (271).

12. Système selon la revendication 11 **caractérisé en ce que** chacune desdites parties (Sa', Sad') sont recombinées optiquement à l'aide d'un composant non linéaire dont la fonction est de comparer les phases.

13. Système selon la revendication 11 **caractérisé en ce qu'**au moins une desdites parties (Sa', Sad') est transformée en signal électrique avant l'entrée du comparateur de phase.

14. Système selon les revendications 11 à 13 **caractérisé en ce que** ledit signal asservi (Sa) et ledit signal asservi déphasé (Sad) sont chacun transformés en signal électrique hyperfréquence à l'aide d'un composant optoélectronique (33,34) afin de générer lesdits signaux en phase (Sas2) et en quadrature (Sas1).

15. Système selon la revendication 10 **caractérisé en ce que** ledit signal asservi (Sa) et ledit signal asservi déphasé (Sad) sont chacun transformés en signal électrique hyperfréquence à l'aide d'un composant optoélectronique (33, 34), dont une partie (Sa', Sad') est prélevée par des moyens de prélèvement (22, 23), chacune desdites parties (Sa', Sad') constituant une entrée du comparateur de phase (27).

16. Système d'émission et de réception pour radar comprenant :

   - un système de démodulation I/Q d'un signal hyperfréquence (S) comprenant un dispositif à verrouillage de fréquence (21) selon l'une des revendications précédentes,
   - une chaine d'émission comprenant une antenne d'émission (52) apte à émettre un signal d'émission, ledit signal d'émission étant issu dudit signal asservi (Sa)
   - une chaine de réception comprenant une antenne de réception (51) apte à recevoir un signal de réception, ledit signal de réception générant ledit signal hyperfréquence à démoduler (S).

17. Système d'émission et de réception pour lidar comprenant :

   - un système de démodulation I/Q d'un signal hyperfréquence (S) comprenant un dispositif à verrouillage de fréquence (21) selon l'une des revendications 10 à 15 ;
   - une chaine d'émission d'une onde optique comprenant un élément émetteur (62) apte à émettre un signal optique d'émission, ledit signal optique d'émission étant issu dudit signal asservi (Sa), ledit signal asservi étant généré par un laser (261);
   - une chaine de réception d'une onde optique comprenant un élément récepteur (61) apte à recevoir un signal optique de réception, ledit signal optique de réception étant transformé en signal hyperfréquence par un composant optoélectronique (64) avant de générer ledit signal à démoduler (S).

**Patentansprüche**

1. System zur I/Q-Demodulation eines Mikrowellensignals (S) auf der Basis eines phasengleichen Mikrowellensignals (Sas2) und eines Quadratur-Mikrowellensignals (Sas1),
   **dadurch gekennzeichnet, dass** es eine Frequenzsperrvorrichtung (21) zum Erzeugen der phasengleichen und Quadratur-Signale (Sas2, Sas1) umfasst, wobei die Frequenzsperrvorrichtung Folgendes umfasst:

   - einen frequenzabstimmbaren Generator (26, 261), der mit einem Steuersignal (Sc) gesteuert werden kann, wobei der Generator ein frequenzgeregeltes Signal (Sa) liefert;

- wenigstens einen ersten Phasenschieber (25, 251), der eine Phasenverschiebung (φ) in das geregelte Signal einführt und am Ausgang des Phasenschieber ein phasenverschobenes geregeltes Signal (Sad) erzeugt;

- wobei die Phasenverschiebung (φ) von der Frequenz des Signals abhängig ist, dessen Phase zu verschieben ist;

- einen Phasenkomparator (27, 271), der die Phase des geregelten Signals (Sa) und die Phase des phasenverschobenen geregelten Signals (Sad) vergleicht und ein Ausgangssignal liefert, das von der Differenz zwischen den Phasen abhängig ist;

- wobei das Ausgangssignal das Steuersignal (Sc) des Generators (26, 261) erzeugt, so dass die Frequenz des Generators (26, 261) angepasst wird, so dass die Phase des geregelten Signals (Sa) und die Phase des phasenverschobenen geregelten Signals (Sad) eine Differenz im Wesentlichen gleich einem ungeradzahligen Vielfachen von $\pi/2$ aufweist;

- wobei die geregelten Signale (Sa) und das phasenverschobene geregelte Signal (Sad) die phasengleichen (Sas2) und Quadratur-(Sasl)-Mikrowellensignale erzeugen können, die die I/Q-Demodulation des Mikrowellensignals (S) realisieren können.

2. System nach Anspruch 1, **dadurch gekennzeichnet, dass** das geregelte Signal (Sa) ferner von einem zweiten Phasenschieber phasenverschoben wird, und dadurch, dass der Phasenkomparator (27, 271) die jeweiligen Phasen der beiden phasenverschobenen geregelten Signale vergleicht.

3. System nach den Ansprüchen 1 bis 2, **dadurch gekennzeichnet, dass** der wenigstens eine der Phasenschieber ein dispersives Filter umfasst.

4. System nach einem der Ansprüche 1 bis 2, **dadurch gekennzeichnet, dass** der wenigstens eine der Phasenschieber eine Verzögerungsleitung umfasst.

5. System nach einem der vorherigen Ansprüche, **dadurch gekennzeichnet, dass** der wenigstens eine der Phasenschieber ein optischer Phasenschieber (251) ist, der durch optische Mittel erhalten wird.

6. System nach Anspruch 5, **dadurch gekennzeichnet, dass** der optische Phasenschieber ein optisches Resonanzfilter umfasst.

7. System nach Anspruch 5, **dadurch gekennzeichnet, dass** der optische Phasenschieber eine Verzögerungsleitung umfasst, die auf den optischen Strahl wirkt.

8. System nach Anspruch 7, **dadurch gekennzeichnet, dass** die Verzögerungsleitung eine optische Faser ist.

9. System nach einem der Ansprüche 5 bis 8, **dadurch gekennzeichnet, dass** der optische Phasenschieber (251) einen Laser, der eine modulierte optische Welle mit einer zum Mikrowellenbereich gehörenden Frequenz erzeugt, und eine schnelle Fotodiode umfasst.

10. System nach einem der Ansprüche 1 bis 8, **dadurch gekennzeichnet, dass** der abstimmbare Generator ein Laser (261) ist, der eine modulierte optische Welle mit einer zum Mikrowellenbereich gehörenden Frequenz erzeugt.

11. System nach Anspruch 10, **dadurch gekennzeichnet, dass** das geregelte Signal (Sa) und das phasenverschobene geregelte Signal (Sad) optische Strahlen sind, von denen ein Teil (Sa', Sad') von Probenahmemitteln (36, 37) genommen wird, wobei jeder der Teile einen Eingang des Phasenkomparators (271) bildet.

12. System nach Anspruch 11, **dadurch gekennzeichnet, dass** jeder der Teile (Sa', Sad') optisch mittels einer nichtlinearen Komponente kombiniert wird, deren Funktion das Vergleichen der Phasen ist.

13. System nach Anspruch 11, **dadurch gekennzeichnet, dass** wenigstens einer der Teile (Sa', Sad') vor dem Eingang des Phasenkomparators in ein elektrisches Signal umgewandelt wird.

14. System nach den Ansprüchen 11 bis 13, **dadurch gekennzeichnet, dass** das geregelte Signal (Sa) und das phasenverschobene geregelte Signal (Sad) jeweils mittels einer optoelektronischen Komponente (33, 34) in ein elektrisches Mikrowellensignal umgewandelt werden, um phasengleiche (Sas2) und Quadratur-(Sas1)-Signale zu erzeugen.

**15.** System nach Anspruch 10, **dadurch gekennzeichnet, dass** das geregelte Signal (Sa) und das phasenverschobene geregelte Signal (Sad) jeweils mit einer optoelektronischen Komponente (33, 34) in ein elektrisches Mikrowellensignal umgewandelt werden, von dem ein Teil (Sa', Sad') von Probenahmemitteln (22, 23) genommen wird, wobei jeder der Teile (Sa', Sad') einen Eingang des Phasenkomparators (27) bildet.

**16.** Sende- und Empfangssystem für ein Radar, das Folgendes umfasst:

- ein System zur I/Q-Demodulation eines Mikrowellensignals (S), umfassend eine Frequenzsperrvorrichtung (21) nach einem der vorherigen Ansprüche,
- eine Sendekette, umfassend eine Sendeantenne (52), die ein Sendesignal aussenden kann, wobei das Sendesignal von dem geregelten Signal (Sa) kommt,
- eine Empfangskette, die eine Empfangsantenne (51) umfasst, die ein Empfangssignal empfangen kann, wobei das Empfangssignal das zu demodulierende Mikrowellensignal (S) erzeugt.

**17.** Sende- und Empfangssystem für ein Lidar, das Folgendes umfasst:

- ein System zur I/Q-Demodulation eines Mikrowellensignals (S), das eine Frequenzsperrvorrichtung (21) nach einem der Ansprüche 10 bis 15 umfasst;
- eine Sendekette einer optischen Welle, umfassend ein Senderelement (62), das ein optisches Sendesignal aussenden kann, wobei das optische Sendesignal von dem geregelten Signal (Sa) kommt, wobei das geregelte Signal von einem Laser (261) erzeugt wird;
- eine Empfangskette einer optischen Welle, umfassend ein Empfängerelement (61), das ein optisches Empfangssignal empfangen kann, wobei das optische Empfangssignal von einer optoelektronischen Komponente (64) vor dem Erzeugen des zu demodulierenden Signals (S) in ein Mikrowellensignal umgeformt wird.

**Claims**

**1.** System for I/Q demodulation of a microwave signal (S) from an in-phase microwave signal (Sas2) and an in-quadrature microwave signal (Sas1),
**characterised in that** it comprises a frequency locking device (21) for generating the in-phase and in-quadrature signals (Sas2, Sas1), the frequency locking device comprising:

- a generator (26, 261) which can be tuned in terms of frequency and which is capable of being controlled by a control signal (Sc), the generator providing a signal (Sa) which is locked-in in terms of frequency;
- at least a first phase shifter (25, 251) which introduces a phase shift (φ) to the locked-in signal and which generates at the output of the phase shifter a phase-shifted locked-in signal (Sad);
- the phase shift (φ) being a function of the frequency of the signal to be phase-shifted;
- a phase comparator (27, 271) which compares the phase of the locked-in signal (Sa) and the phase of the phase-shifted locked-in signal (Sad) and which provides an output signal which is a function of the difference between the phases;
- the output signal generating the control signal (Sc) of the generator (26, 261) so that the frequency of the generator (26, 261) is adapted so that the phase of the locked-in signal (Sa) and the phase of the phase-shifted locked-in signal (Sad) have a difference which is substantially equal to an odd multiple of $\pi/2$;
- the locked-in signals (Sa) and phase-shifted locked-in signal (Sad) being capable of generating the in-phase (Sas2) and in-quadrature microwave signals (Sas1) which are capable of producing the I/Q demodulation of the microwave signal (S).

**2.** System according to claim 1, **characterised in that** the locked-in signal (Sa) is further phase-shifted by a second phase shifter and **in that** the phase comparator (27, 271) compares the respective phases of the two phase-shifted locked-in signals.

**3.** System according to claims 1 and 2, **characterised in that** the at least one of the phase shifters comprises a dispersive filter.

**4.** System according to claims 1 and 2, **characterised in that** the at least one of the phase shifters comprises a delay line.

**5.** System according to any one of the preceding claims, **characterised in that** the at least one of the phase shifters is an optical phase shifter (251) which is obtained using optical means.

6. System according to claim 5, **characterised in that** the optical phase shifter comprises an optical resonant filter.

7. System according to claim 5, **characterised in that** the optical phase shifter comprises a delay line which acts on the optical beam.

8. System according to claim 7, **characterised in that** the delay line is an optical fibre.

9. System according to any one of claims 5 to 8, **characterised in that** the optical phase shifter (251) comprises a laser which generates an optical wave which is modulated at a frequency which belongs to the range of hyperfrequencies and a rapid photodiode.

10. System according to any one of claims 1 to 8, **characterised in that** the tunable generator is a laser (261) which generates an optical wave which is modulated at a frequency which belongs to the range of hyperfrequencies.

11. System according to claim 10, **characterised in that** the locked-in signal (Sa) and the phase-shifted locked-in signal (Sad) are optical beams, a portion (Sa', Sad') of which is sampled by sampling means (36, 37), each of the portions constituting an input of the phase comparator (271).

12. System according to claim 11, **characterised in that** each of the portions (Sa', Sad') is optically recombined using a non-linear component whose function is to compare the phases.

13. System according to claim 11, **characterised in that** at least one of the portions (Sa', Sad') is converted into an electrical signal before entering the phase comparator.

14. System according to claims 11 to 13, **characterised in that** the locked-in signal (Sa) and the phase-shifted locked-in signal (Sad) are each converted into a microwave electrical signal using an optoelectronic component (33, 34) in order to generate the in-phase (Sas2) and in-quadrature signals (Sas1).

15. System according to claim 10, **characterised in that** the locked-in signal (Sa) and the phase-shifted locked-in signal (Sad) are each converted into a microwave electrical signal using an optoelectronic component (33, 34), a portion (Sa', Sad') of which is sampled by sampling means (22, 23), each of the portions (Sa', Sad') constituting an input of the phase comparator (27).

16. Emission and reception system for a radar comprising:

   - a system for I/Q demodulation of a microwave signal (S) comprising a frequency locking device (21) according to any one of the preceding claims,
   - an emission chain comprising an emission antenna (52) which is capable of emitting an emission signal, the emission signal originating from the locked-in signal (Sa),
   - a receiving chain comprising a receiving antenna (51) which is capable of receiving a receiving signal, the receiving signal generating the microwave signal to be demodulated (S).

17. Emission and reception system for a lidar comprising:

   - an I/Q demodulation system for a microwave signal (S) comprising a frequency locking device (21) according to any one of claims 10 to 15;
   - a chain for emission of an optical wave comprising an emission element (62) which is capable of emitting an optical emission signal, the optical emission signal originating from the locked-in signal (Sa), the locked-in signal being generated by a laser (261);
   - a chain for receiving an optical wave comprising a receiving element (61) which is capable of receiving an optical receiving signal, the optical receiving signal being converted into a microwave signal by an optoelectronic component (64) before generating the signal to be demodulated (S).

FIG.1

FIG.3

FIG.2

FIG.4

FIG.5

EP 2 575 311 B1

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5150128 A